# EUROPEAN PATENT SPECIFICATION

(11) **EP 3 598 855 B1**
(45) Date of publication and mention of the grant of the patent: **17.04.2024**
(21) Application number: 18847835.8
(22) Date of filing: 27.04.2018
(51) Int. Cl.: H05K 1/02, H05K 3/00

(54) **POSITIONING STRUCTURE AND FLEXIBLE CIRCUIT BOARD**
POSITIONIERUNGSSTRUKTUR UND FLEXIBLE LEITERPLATTE
STRUCTURE DE POSITIONNEMENT ET CARTE DE CIRCUIT IMPRIMÉ FLEXIBLE

(30) Priority: 23.08.2017 CN 201721062229 U
(43) Date of publication of application: 22.01.2020
(73) Proprietor: Kunshan Go-Visionox Opto-Electronics Co., Ltd., KunShan City, Jiangsu 215300 (CN)
(72) Inventor: ZHANG, Tan, Jiangsu 215300 (CN); SUN, Zhan, Jiangsu 215300 (CN)
(74) Representative: D'Halleweyn, Nele Veerle Trees Gertrudis
(86) International application number: PCT/CN2018/084881
(87) International publication number: WO 2019/037460

(56) References cited:
- CN-U- 201 616 955
- CN-U- 203 194 007
- CN-U- 203 279 331
- CN-U- 205 283 935
- JP-B2- H0 760 917
- US-A- 5 585 157
- US-A- 6 150 614

## Description

### TECHNICAL FIELD

The present invention relates to the field of bonding technology, and in particular to a positioning structure and a flexible printed circuit.

### BACKGROUND

A flexible printed circuit is a printed circuit board made of a flexible insulating substrate, and is capable of being bent, wound and folded freely. The flexible printed circuit is available in single-sided, multi-sided and multi-layer boards and other types, and it is mainly formed by laying a cover film with mechanical protection and good electrical insulation properties on a surface of the flexible insulating substrate and pressing the cover film to the surface of the flexible insulating substrate.

However, in an existing FOF (i.e., FPC ON FPC, Flexible Printed Circuit bonding Flexible Printed Circuit) process, because a material around a positioning hole of the flexible printed circuit is soft and weak, the positioning hole is prone to deformation under action of a positioning device force and other external forces, and the deformed positioning hole may result in inaccurate positioning and even result in bonding failure of the flexible printed circuit during a positioning process.

US 5 585 157 A discloses a printed substrate having a structure to prevent breakage of the printed substrate by distributing stress which acts on a border of reinforcement patterns provided in the substrate. The printed substrate includes multiple layer conductive patterns, through-holes which pass through the conductive patterns and the printed substrate, and reinforcement patterns formed around the perimeters of the through-holes in the multiple layers of the printed substrate. The sizes and/or shapes of the reinforcement patterns in each layer differ such that stress acting on the border of the reinforcement pattern is distributed.

US 6 150614 A discloses a conductor foil for conductively connecting electrical and/or electronic components. In the conductor foil for conductively connecting electrical and/or electronic components, the conductor foil including printed circuit traces, insulated to the outside and applied on a non-conductive, elastically malleable carrier foil. The conductive foil also includes soldering surfaces connected to the printed circuit traces, for soldering to electric terminals of components, in addition, the conductor foil includes feed line segments through which the printed circuit traces are led to the soldering surfaces, in order, in response to shaking stresses, to avoid damage to the soldering points by vibradons transmitted by the feed line segments. Furthermore, the conductor foil has stiffening segments branching off from the feed line segments, the stiffening segments, in response to shaking stresses, causing a force diversion of the vibradons onto the stiffening segments via the feed line segment movable end, which is not connected to the soldering surfaces.

### SUMMARY

In view of this, embodiments of the present invention provide a positioning structure and a flexible printed circuit, in order to solve the problem that the positioning hole is easily deformed under action of external forces.

The present invention is defined by the appended claims.

In a first aspect of the present invention, a positioning structure according to an embodiment of the present invention includes a flexible substrate having a positioning hole therein and at least one reinforcing layer disposed on the flexible substrate and located within a preset range around a periphery of the positioning hole to reinforce the positioning hole, and each reinforcing layer includes a hole corresponding to the positioning hole. Each reinforcing layer includes a sublayer configured to improve a strength of the positioning hole, disposed on the flexible substrate and located within the preset range around the periphery of the positioning hole, the sublayer including a hole aligned with the positioning hole. The sublayer includes a plurality of segments, and the segments are annularly distributed along the periphery of the positioning hole.

In an embodiment of the present invention, each reinforcing layer further includes a protective film disposed on the flexible substrate and located within the preset range around the periphery of the positioning hole, and the sublayer is partially or entirely covered by the protective film.

In an embodiment of the present invention, each reinforcing layer further includes a protective film disposed on the flexible substrate and located within a preset range around the sublayer, and an inner periphery of the protective film coincides with an outer periphery of the sublayer.

In an embodiment of the present invention, the sublayer includes a metal plating layer or a hard coating layer or a strengthening layer.

In an embodiment of the present invention, the positioning hole is circular-shaped, the protective film is annular-shaped, and the sublayer is annular-shaped.

In an embodiment of the present invention, the positioning hole is circular-shaped, the protective film is annular-shaped, and each of the plurality of segments is one of a circular shape, a fan shape, a semicircular shape, and an irregular shape.

In an embodiment of the present invention, a distance between an outer periphery of each reinforcing layer and a periphery of the positioning hole is in a range of 0 mm to 10 mm.

In an embodiment of the present invention, the at least one reinforcing layer corresponds to a plurality of reinforcing layers.

In an embodiment of the present invention, the plurality of reinforcing layers are disposed on an upper and/or a lower surface of the flexible substrate having the positioning hole.

In an embodiment of the present invention, each reinforcing layer includes a plurality of sublayers, and materials of the plurality of sublayers are the same or different.

In a second aspect of the present invention, a flexible printed circuit according to an embodiment of the present invention includes an electronic device and the positioning structure according to the first aspect described.

In the positioning structure according to the embodiments of the present invention, the strength of the positioning hole is improved and an undesirable deformation phenomenon of the positioning hole under action of external forces is prevented, by disposing the positioning hole on the flexible substrate and laying the reinforcing layer in the preset range around the periphery of the positioning hole.

### BRIEF DESCRIPTION OF DRAWINGS

FIG. 1 is a structural schematic diagram of a positioning structure according to a first embodiment which is not covered by the present invention.
FIG. 2 is a structural schematic diagram of a positioning structure according to a second embodiment which is not covered by the present invention.
FIG. 3 is a structural schematic diagram of a positioning structure according to a third embodiment which is not covered by the present invention.
FIG. 4 is a structural schematic diagram of a positioning structure according to a fourth embodiment of the present invention.
FIG. 5 is a structural schematic diagram of a positioning structure according to a fifth embodiment of the present invention.
FIG. 6 is a structural schematic diagram of a positioning structure according to a sixth embodiment of the present invention.

### DETAILED DESCRIPTION

In order to make objects, technical means and advantages of the present invention more comprehensible, the present invention is to be further described in detail below with reference to accompanying drawings. The advantages and features of the present invention will be more apparent according to following description and claims. It may be noted that the accompanying drawings are all in a very simplified form and all use non-precise proportions, so as to conveniently and clearly state embodiments of the present invention.

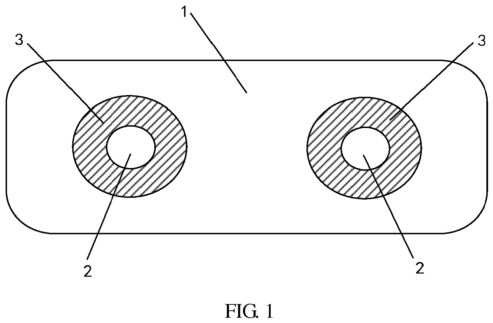

FIG. 1 is a structural schematic diagram of a positioning structure according to a first embodiment which is not covered by the present invention. As shown in FIG.1, the positioning structure according to the first embodiment includes a flexible substrate 1 having positioning holes 2 therein and reinforcing layers 3. The reinforcing layers 3 are disposed on the flexible substrate 1 and are located within preset ranges around peripheries of the positioning holes 2 to reinforce the positioning holes 2. The reinforcing layers 3 have holes corresponding to the positioning holes 2.

In the positioning structure according to the first embodiment, the positioning holes 2 are disposed on the flexible substrate 1 and the reinforcing layers 3 are laid in the preset ranges around the peripheries of the positioning holes 2. Therefore, the strength of the positioning holes 2 is improved and an undesirable deformation phenomenon of the positioning holes 2 under action of external forces is prevented.

It may be understood that the holes in the reinforcing layers 3 may be the same size as the positioning hole 2 or may be larger than the positioning hole 2.

It may be understood that the preset ranges in which the reinforcing layers 3 are disposed around the peripheries of the positioning holes 2 may be freely set according to an actual condition. For example, the preset ranges may be set from 0 mm to 10 mm, that is, distances between outer peripheries of the reinforcing layers 3 and the peripheries of the positioning holes 2 are in a range of 0 mm to 10 mm, which will improve functions of the reinforcing layers 3 without impacting structures around the positioning holes 2. In addition, a size of the preset range may also be set according to the size of the positioning hole 2. For example, the larger a radius of the positioning hole 2, the larger the preset range is.

It may be understood that the sizes and shapes of the positioning holes 2 formed on the flexible substrate 1 may be freely set according to the actual condition. For example, the positioning holes 2 are set to be circular holes with the radius of 5 mm, and the embodiments of the present invention are not limited to this. Instead, the shapes of the positioning holes 2 may also be square or oval.

It may be understood that the reinforcing layers 3 may be disposed on an upper and/or a lower surface of the flexible substrate 1 on which the positioning holes 2 are formed, so as to substantially enhance the expansibility and the adaptability of the positioning structure according to the embodiments.

In an embodiment, the reinforcing layer 3 is an annulate strip, an inner periphery of the reinforcing layer 3 coincides with the periphery of the positioning hole 2. With arranging the reinforcing layer 3 as the annulate strip, the positioning hole 2 is fixed sufficiently by the reinforcing layer 3 and material cost and resources are saved at the same time. It may be understood that a shape of the reinforcing layer 3 may also be set according to the shape of the positioning hole 2. For example, when the shape of the positioning hole 2 is square, the reinforcing layer 3 may be a square ring, and when the shape of the positioning hole 2 is elliptical, the reinforcing layer 3 may be an elliptical ring. Certainly, the shape of the reinforcing layer 3 may also be different from the shape of the positioning hole 2. For example, when the shape of the positioning hole 2 is circular-shaped, the reinforcing layer 3 may be a square ring.

It may be understood that the shape of the reinforcing layer 3 may be set freely according to the actual condition. For example, the reinforcing layer 3 may include a plurality of segments, and the plurality of segments are annularly distributed along the periphery of the positioning hole 2 so as to reinforce the positioning hole 2. In addition, shapes of the segments may be freely set according to the actual condition, and the shapes of the segments include one or a combination of following shapes: a diamond shape, a circle shape, a fan shape and so on.

In an embodiment, the flexible substrate 1 is a flexible printed circuit. In an actual application process, when a Driver Flexible Printed Circuit (Driver FPC) and a Touch Panel Flexible Printed Circuit (TP FPC) are required to be bonded to achieve electrical conduction, positioning holes 2 of the Driver FPC and/or positioning holes 2 of the TP FPC are subjected to a treatment of laying the reinforcing layers 3 on an upper and/or a lower surface, so as to sufficiently increase the strength and the hardness of the positioning holes 2, and make the positioning holes 2 on the flexible printed circuit sufficiently adapt to different actual conditions and usage requirements. Therefore, the adaptability and the expansibility of the positioning structure according to the embodiments are increased.

In an embodiment, materials of the reinforcing layers 3 include, but are not limited to, a polyimide film, a cover film, a cover layer and other materials, which have both insulation protection and reinforcing effects. In addition, it may be understood that each reinforcing layer 3 may include one or more sublayers, and the number of the sublayers and materials of the sublayers may be set freely according to the actual condition.

According to the first embodiment, in the actual application process, the positioning holes 2 are formed in the flexible substrate 1, and the reinforcing layers 3 are disposed on the peripheries of the positioning holes 2 of at least one surface of the flexible substrate 1. Therefore, the strength and the hardness of the peripheries of the positioning holes 2 are strengthened, so as to prevent the positioning holes 2 from being deformed by the external forces.

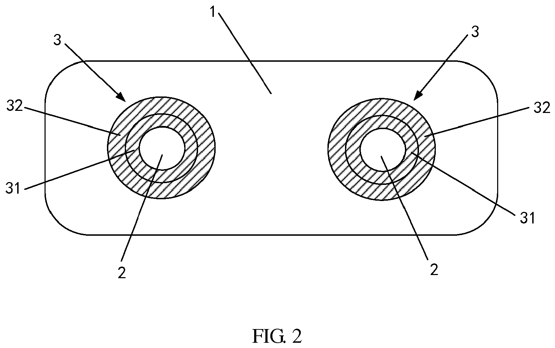

FIG. 2 is a structural schematic diagram of a positioning structure according to a second embodiment which is not covered by the present invention. As shown in FIG. 2, the positioning structure according to the second embodiment is substantially the same as the positioning structure according to the first embodiment of the present invention. The following only highlights differences, and similarities are not repeated here. A reinforcing layer 3 in the positioning structure according to the second embodiment includes a hard layer 31 and a protective film 32, and the hard layer 31 and the protective film 32 are laid on a same surface of a flexible substrate 1. An inner periphery of the hard layer 31 coincides with a periphery of a positioning hole 2. The protective film 32 is attached to a side of the hard layer 31 that is away from the positioning hole 2, and the hard layer 31 is partially or entirely covered by the protective film 32.

In an embodiment, the hard layer 31 is an annulate strip, and an inner periphery of the hard layer 31 coincides with the periphery of the positioning hole 2.

In an embodiment, the hard layer 31 is a metal plating layer made of a copper foil.

In an embodiment, the hard layer 31 is a metal plating layer made of an aluminum foil.

In an embodiment, the hard layer 31 is a sprayed hard coating layer.

In an embodiment, the hard layer 31 is a strengthening layer.

In an embodiment, a material of the strengthening layer includes, but is not limited to, a cover film or a cover layer, etc., which have both insulation protection and reinforcing effects. In addition, it may be understood that each strengthening layer may include one or more sublayers, and the number of the sublayers and the materials of the sublayers may be set freely according to an actual condition.

In an embodiment, the protective film 32 also has functions of avoiding oxidation of the hard layer 31, covering for a subsequent surface treatment, and acting as a solder resist in subsequent Surface Mount Technology (SMT).

In an actual application process, the positioning holes 2 are formed in the flexible substrate 1, and the hard layers 31 are laid on peripheries of the positioning holes 2 of at least one surface of the flexible substrate 1. The protective films 32 are laid on sides of the hard layers 31 which are away from the flexible substrate 1. An inner periphery of the protective film 32 and the inner periphery of the hard layer 31 are coincided, and an outer periphery of the protective film 32 is larger than an outer periphery of the hard layer 31.

In the positioning structure according to the second embodiment, the positioning holes 2 are formed on the flexible substrate 1, the reinforcing layers 3 are laid along the peripheries of the positioning holes 2, the reinforcing layer 3 includes the hard layer 31 and the protective film 32, and the hard layer 31 and the protective film 32 are laid on the same surface of the flexible substrate 1, the inner periphery of the hard layer 31 and the periphery of the positioning hole 2 are coincided, the protective film 32 is attached to the side of the hard layer 31 that is away from the positioning hole 2, and the hard layer 31 is partially or entirely covered by the protective film 32. Therefore, the strength of the positioning holes 2 is improved, an undesirable deformation of the positioning holes 2 under external forces is prevented, and positioning accuracy decrease of the positioning holes 2 caused by the undesirable deformation of the positioning holes 2 is avoided.

In an embodiment, the reinforcing layer 3 contains the hard layer 31 and excludes the protective film 32. The hard layer 31 is disposed on the flexible substrate 1 and is located within a preset range around the periphery of the positioning hole 2. The hard layer 31 has a hole aligned with the positioning hole 2. In the positioning structure according to the embodiments of the present invention, the strength of the positioning hole 2 is improved by means of the hard layer 31, so as to avoid the undesirable deformation of the positioning hole 2 under the external forces.

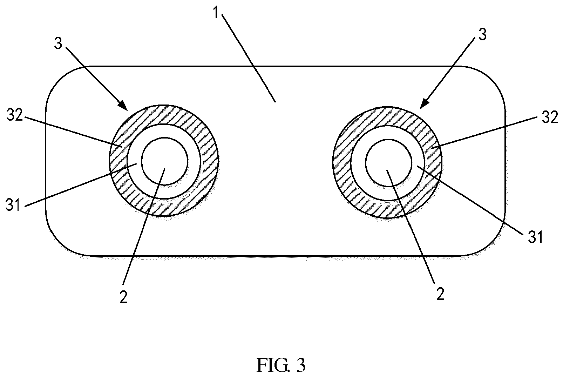

FIG. 3 is a structural schematic diagram of a positioning structure according to a third embodiment which is not covered by the present invention. As shown in FIG. 3, the positioning structure according to the third embodiment is substantially the same as the positioning structure according to the first embodiment. The following only highlights differences, and similarities are not repeated here. A reinforcing layer 3 in the positioning structure according to the third embodiment includes a hard layer 31 and a protective film 32, and the hard layer 31 and the protective film 32 are laid on a same surface of a flexible substrate 1. An inner periphery of the hard layer 31 coincides with a periphery of a positioning hole 2, and an inner periphery of the protective film 32 coincides with an outer periphery of the hard layer 31.

In an embodiment, the hard layer 31 is an annulate strip, and the inner periphery of the hard layer 31 coincides with the periphery of the positioning hole 2.

In an embodiment, the hard layer 31 is a metal plating layer made of a copper foil.

In an embodiment, the hard layer 31 is a metal plating layer made of an aluminum foil.

In an embodiment, the hard layer 31 is a sprayed hard coating layer.

In an actual application process, the positioning holes 2 are formed in the flexible substrate 1, and the hard layers 31 are laid on the peripheries of the positioning holes 2 of at least one surface of the flexible substrate 1. The protective films 32 are laid on sides of the hard layers 31 which are away from the flexible substrate 1, the inner periphery of the protective film 32 and an outer periphery of the hard layer 31 are coincided.

In the positioning structure according to the third embodiment, the positioning holes 2 are formed on the flexible substrate 1, the reinforcing layers 3 are laid along the peripheries of the positioning holes 2, the reinforcing layer 3 includes the hard layer 31 and the protective film 32, and the hard layer 31 and the protective film 32 are laid on the same surface of the flexible substrate 1, the inner periphery of the hard layer 31 and the periphery of the positioning hole 2 are coincided, the protective film 32 is attached to the side of the hard layer 31 that is away from the positioning hole 2, the inner periphery of the protective film 32 and the outer periphery of the hard layer 31 are coincided. Therefore, the strength of the positioning holes 2 is improved, an undesirable deformation of the positioning holes 2 under external forces is prevented, and positioning accuracy decrease of the positioning holes 2 caused by the undesirable deformation of the positioning holes 2 is avoided.

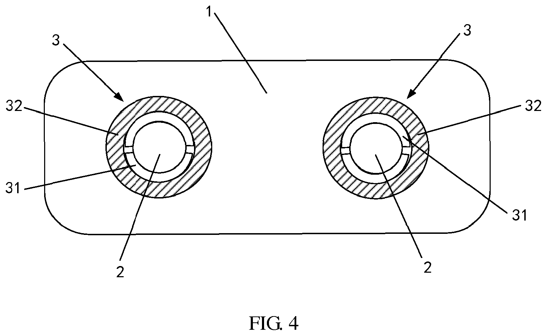

FIG. 4 is a structural schematic diagram of a positioning structure according to a fourth embodiment of the present invention. As shown in FIG. 4, the positioning structure according to the fourth embodiment of the present invention is substantially the same as the positioning structure according to the third embodiment. The following only highlights differences, and similarities are not repeated here. A hard layer 31 in the positioning structure according to the fourth embodiment of the present invention includes two semicircular annulate strips, and the two semicircular annulate strips are evenly distributed along a periphery of a positioning hole 2, inner peripheries of the two semicircular annulate strips and the periphery of the positioning hole 2 are coincided.

In the positioning structure according to the fourth embodiment of the present invention, the positioning holes 2 are formed on a flexible substrate 1, reinforcing layers 3 are laid along the peripheries of the positioning holes 2, the reinforcing layer 3 includes the hard layer 31 and a protective film 32, the hard layer 31 and the protective film 32 are laid on a same surface of the flexible substrate 1, the hard layer 31 is set as the two semicircular annulate strips which are distributed evenly along the periphery of the positioning hole 2, the inner peripheries of the two semicircular annulate strips and the periphery of the positioning hole 2 are coincided, the protective film 32 is attached to a side of the hard layer 31 that is away from the positioning hole 2, an inner periphery of the protective film 32 and an outer periphery of the hard layer 31 are coincided. Therefore, the strength of the positioning holes 2 is improved, an undesirable deformation of the positioning holes 2 under external forces is prevented, and positioning accuracy decrease of the positioning holes 2 caused by the undesirable deformation of the positioning holes 2 is avoided.

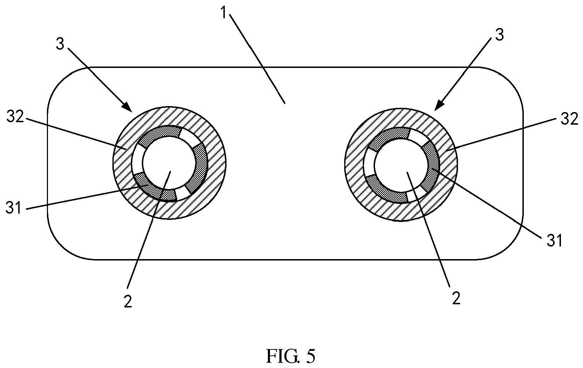

FIG. 5 is a structural schematic diagram of a positioning structure according to a fifth embodiment of the present invention. As shown in FIG. 5, the positioning structure according to the fifth embodiment of the present invention is substantially the same as the positioning structure according to the third embodiment. The following only highlights differences, and similarities are not repeated here. A hard layer 31 in the positioning structure according to the fifth embodiment of the present invention includes three fanning strips, and the three fanning strips are evenly and annularly distributed along a periphery of a positioning hole 2. A fan-shaped gap is included between two adjacent strips, inner peripheries of the three fanning strips and the periphery of the positioning hole 2 are coincided.

In the positioning structure according to the fifth embodiment of the present invention, the positioning holes 2 are formed on a flexible substrate 1, reinforcing layers 3 are laid along the peripheries of the positioning holes 2, a reinforcing layer 3 includes the hard layer 31 and a protective film 32, and the hard layer 31 and the protective film 32 are laid on a same surface of the flexible substrate 1, the hard layer 31 is set as the three fanning strips which are annular distributed evenly along the periphery of the positioning hole 2, the inner peripheries of the three fanning strips and the periphery of the positioning hole 2 are coincided, the protective film 32 is attached to a side of the hard layer 31 that is away from the positioning hole 2, an inner periphery of the protective film 32 and an outer periphery of the hard layer 31 are coincided. Therefore, the strength of the positioning holes 2 is improved, an undesirable deformation of the positioning holes 2 under external forces is prevented, and positioning accuracy decrease of the positioning holes 2 caused by the undesirable deformation of the positioning holes 2 is avoided.

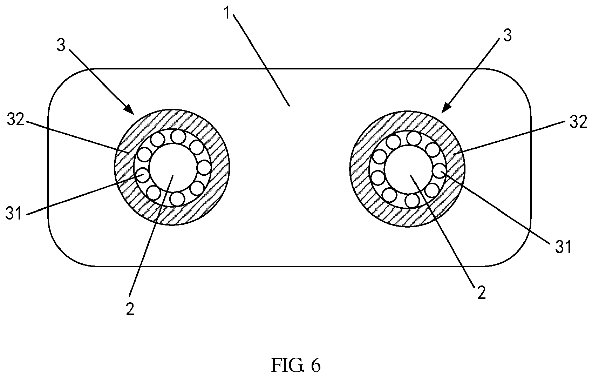

FIG. 6 is a structural schematic diagram of a positioning structure according to a sixth embodiment of the present invention. As shown in FIG. 6, the positioning structure according to the sixth embodiment of the present invention is substantially the same as the positioning structure according to the third embodiment. The following only highlights differences, and similarities are not repeated here. A hard layer 31 in the positioning structure according to the sixth embodiment of the present invention includes a plurality of circular strips, and the plurality of circular strips are evenly and annularly distributed along a periphery of a positioning hole 2.

In the positioning structure according to the sixth embodiment of the present invention, the positioning holes 2 are formed on a flexible substrate 1, reinforcing layers 3 are laid along the peripheries of the positioning holes 2, the reinforcing layer 3 includes the hard layer 31 and a protective film 32, the hard layer 31 and the protective film 32 are laid on a same surface of the flexible substrate 1, the hard layer 31 is set as the plurality of circular strips which are annular distributed evenly along the periphery of the positioning hole 2, the protective film 32 is attached to a side of the hard layer 31 that is away from the positioning hole 2, an inner periphery of the protective film 32 and an outer periphery of the hard layer 31 are coincided. Therefore, the strength of the positioning holes 2 is improved, an undesirable deformation of the positioning holes 2 under external forces is prevented, and positioning accuracy decrease of the positioning holes 2 caused by the undesirable deformation of the positioning holes 2 is avoided.

It may be understood that shapes of the hard layers 31 may be set freely according to an actual condition. The hard layer 31 includes a plurality of segments. Shapes of the segments in the hard layer 31 may be set freely according to the actual condition, and are not limited to the shape mentioned in the above embodiments of the present invention. For example, the shapes of the segments in the hard layer 31 may be elliptical shapes or irregular shapes.

## Claims

1. A positioning structure, comprising:
a flexible substrate (1) having a positioning hole (2);
further comprising at least one reinforcing layer (3) disposed on the flexible substrate (1) and located within a preset range around a periphery of the positioning hole (2) to reinforce the positioning hole (2), each reinforcing layer (3) including a hole corresponding to the positioning hole (2);
wherein each reinforcing layer (3) comprises a sublayer (31) configured to improve a strength of the positioning hole (2), disposed on the flexible substrate (1) and located within the preset range around the periphery of the positioning hole (2), the sublayer (31) including a hole aligned with the positioning hole (2);
**characterized in that** the sublayer (31) comprises a plurality of segments, and the plurality of segments are annularly distributed along the periphery of the positioning hole (2).

2. The positioning structure of claim 1, wherein each reinforcing layer (3) further comprises a protective film (32) disposed on the flexible substrate (1) and located within the preset range around the periphery of the positioning hole (2), and the sublayer (31) is partially or entirely covered by the protective film (32).

3. The positioning structure of claim 2, wherein the positioning hole (2) is circular-shaped, the protective film (32) is annular-shaped, and the sublayer (31) is annular-shaped.

4. The positioning structure of claim 2, wherein the positioning hole (2) is circular-shaped, the protective film (32) is annular-shaped, and each of the plurality of segments is one of or a combination of a circular shape, a fan shape, a semicircular shape and an irregular shape.

5. The positioning structure of claim 1, wherein each reinforcing layer (3) further comprises a protective film (32) disposed on the flexible substrate (1) and located within a preset range around the hard layer (31), and an inner periphery of the protective film (32) coincides with an outer periphery of the sublayer (31).

6. The positioning structure of claim 1, wherein a distance between an outer periphery of each reinforcing layer (3) and a periphery of the positioning hole (2) is in a range of 0 mm to 10 mm.

7. The positioning structure of claims 1 to 6, wherein the at least one reinforcing layer (3) corresponds to a plurality of reinforcing layers (3).

8. The positioning structure of claim 7, wherein the plurality of reinforcing layers (3) are disposed on an upper and/or a lower surface of the flexible substrate (1) having the positioning hole (2).

9. The positioning structure of claims 1 to 8, wherein each reinforcing layer (3) comprises a plurality of sublayers, and materials of the plurality of sublayers are the same or different.

10. A flexible printed circuit, comprising:
an electronic device;
**characterized by** further comprising the positioning structure according to any one of claims 1 to 9.

## Patentansprüche

1. Positionierungsstruktur, umfassend:
ein flexibles Substrat (1), das ein Positionierungsloch (2) aufweist;
ferner umfassend mindestens eine Verstärkungsschicht (3), die auf dem flexiblen Substrat (1) angeordnet ist und sich innerhalb eines voreingestellten Bereichs um einen Umfang des Positionierungslochs (2) herum befindet, um das Positionierungsloch (2) zu verstärken, wobei jede Verstärkungsschicht (3) ein Loch einschließt, das dem Positionierungsloch (2) entspricht;
wobei jede Verstärkungsschicht (3) eine Teilschicht (31) umfasst, die konfiguriert ist, um eine Festigkeit des Positionierungslochs (2) zu verbessern, das auf dem flexiblen Substrat (1) angeordnet ist und sich innerhalb des voreingestellten Bereichs um den Umfang des Positionierungslochs (2) herum befindet, wobei die Teilschicht (31) ein Loch einschließt, das mit dem Positionierungsloch (2) ausgerichtet ist;
**dadurch gekennzeichnet, dass** die Teilschicht (31) eine Vielzahl von Segmenten umfasst und die Vielzahl Segmenten entlang des Umfangs des Positionierungslochs (2) ringförmig verteilt sind.

2. Positionierungsstruktur nach Anspruch 1, wobei jede Verstärkungsschicht (3) ferner einen Schutzfilm (32) umfasst, der auf dem flexiblen Substrat (1) angeordnet ist und sich innerhalb des voreingestellten Bereichs um den Umfang des Positionierungslochs (2) herum befindet, und die Teilschicht (31) teilweise oder vollständig von dem Schutzfilm (32) bedeckt ist.

3. Positionierungsstruktur nach Anspruch 2, wobei das Positionierungsloch (2) kreisförmig ist, der Schutzfilm (32) ringförmig ist und die Teilschicht (31) ringförmig ist.

4. Positionierungsstruktur nach Anspruch 2, wobei das Positionierungsloch (2) kreisförmig ist, der Schutzfilm (32) ringförmig ist und jedes der Vielzahl von Segmenten eines von oder eine Kombination aus einer Kreisform, einer Fächerform, einer Halbkreisform und einer unregelmäßigen Form ist.

5. Positionierungsstruktur nach Anspruch 1, wobei jede Verstärkungsschicht (3) ferner einen Schutzfilm (32) umfasst, der auf dem flexiblen Substrat (1) angeordnet ist und sich innerhalb eines voreingestellten Bereichs um die harte Schicht (31) herum befindet, und ein innerer Umfang des Schutzfilms (32) mit einem äußeren Umfang der Teilschicht (31) übereinstimmt.

6. Positionierungsstruktur nach Anspruch 1, wobei ein Abstand zwischen einem äußeren Umfang jeder Verstärkungsschicht (3) und einem Umfang des Positionierungslochs (2) in einem Bereich von 0 mm bis 10 mm liegt.

7. Positionierungsstruktur nach Anspruch 1 bis 6, wobei die mindestens eine Verstärkungsschicht (3) einer Vielzahl von Verstärkungsschichten (3) entspricht.

8. Positionierungsstruktur nach Anspruch 7, wobei die Vielzahl von Verstärkungsschichten (3) an einer oberen und/oder einer unteren Oberfläche des flexiblen Substrats (1), das ein Positionierungsloch (2) aufweist, angeordnet sind.

9. Positionierungsstruktur nach Anspruch 1 bis 8, wobei jede Verstärkungsschicht (3) eine Vielzahl von Teilschichten umfasst und Materialien der Vielzahl von Teilschichten gleich oder unterschiedlich sind.

10. Flexible Leiterplatte, umfassend:
eine elektronische Vorrichtung;
**dadurch gekennzeichnet, dass** sie ferner die Positionierungsstruktur nach einem der Ansprüche 1 bis 9 umfasst.

## Revendications

1. Structure de positionnement, comprenant :
un substrat flexible (1) ayant un trou de positionnement (2) ;
comprenant en outre au moins une couche de renfort (3) disposée sur le substrat flexible (1) et localisée au sein d'une plage prédéfinie autour d'une périphérie du trou de positionnement (2) pour renforcer le trou de positionnement (2), chaque couche de renfort (3) comportant un trou correspondant au trou de positionnement (2) ;
dans laquelle chaque couche de renfort (3) comprend une sous-couche (31) configurée pour améliorer une résistance du trou de positionnement (2), disposée sur le substrat flexible (1) et localisée au sein de la plage prédéfinie autour de la périphérie du trou de positionnement (2), la sous-couche (31) comportant un trou aligné avec le trou de positionnement (2) ;
**caractérisée en ce que** la sous-couche (31) comprend une pluralité de segments, et la pluralité de segments sont répartis annulairement le long de la périphérie du trou de positionnement (2).

2. Structure de positionnement selon la revendication 1, dans laquelle chaque couche de renfort (3) comprend en outre un film protecteur (32) disposé sur le substrat flexible (1) et localisé au sein de la plage prédéfinie autour de la périphérie du trou de positionnement (2), et la sous-couche (31) est partiellement ou entièrement couverte par le film protecteur (32).

3. Structure de positionnement selon la revendication 2, dans laquelle le trou de positionnement (2) est de forme circulaire, le film protecteur (32) est de forme annulaire, et la sous-couche (31) est de forme annulaire.

4. Structure de positionnement selon la revendication 2, dans laquelle le trou de positionnement (2) est de forme circulaire, le film protecteur (32) est de forme annulaire, et chacun parmi la pluralité de segments est l'un ou une combinaison parmi une forme circulaire, une forme d'éventail, une forme semi-circulaire et une forme irrégulière.

5. Structure de positionnement selon la revendication 1, dans laquelle chaque couche de renfort (3) comprend en outre un film protecteur (32) disposé sur le substrat flexible (1) et localisé au sein d'une plage prédéfinie autour de la couche dure (31), et une périphérie interne du film protecteur (32) coïncide avec une périphérie externe de la sous-couche (31).

6. Structure de positionnement selon la revendication 1, dans laquelle une distance entre une périphérie externe de chaque couche de renfort (3) et une périphérie du trou de positionnement (2) est dans une plage de 0 mm à 10 mm.

7. Structure de positionnement selon les revendications 1 à 6, dans laquelle l'au moins une couche de renfort (3) correspond à une pluralité de couches de renfort (3).

8. Structure de positionnement selon la revendication 7, dans laquelle la pluralité de couches de renfort (3) sont disposées sur une surface supérieure et/ou inférieure du substrat flexible (1) ayant le trou de positionnement (2).

9. Structure de positionnement selon les revendications 1 à 8, dans laquelle chaque couche de renfort (3) comprend une pluralité de sous-couches, et les matériaux de la pluralité de sous-couches sont identiques ou différents.

10. Circuit imprimé flexible, comprenant :
un dispositif électronique ;
**caractérisé en ce qu'**il comprend en outre la structure de positionnement selon l'une quelconque des revendications 1 à 9.
